# EUROPEAN PATENT APPLICATION

(11) **EP 4 539 120 A1**
(43) Date of publication of application: **16.04.2025**
(21) Application number: 24186086.5
(22) Date of filing: 02.07.2024
(51) Int. Cl.: H01L 23/522

(54) **CAPACITIVE VOLTAGE REGULATOR IN INTEGRATED CIRCUIT PACKAGE**

(30) Priority: 29.09.2023 US 202318478840
(71) Applicant: INTEL Corporation, Santa Clara, CA 95054 (US)
(72) Inventor: RAVICHANDRAN, Krishnan, Saratoga, 95070 (US); RADHAKRISHNAN, Kaladhar, Chandler, 85226 (US); DOUGLAS, Jonathan, Cave Creek, 85331 (US); KRISHNAMURTHY, Harish, Beaverton, 97006 (US); AHMED, Khondker, Hilsboro, 97124 (US); SU HWAN, Kim, Portland, 97225 (US); DESAI, Nachiket, Portland, 97229 (US); BUTZEN, Nicolas, Portland, 97229 (US)
(74) Representative: HGF

(57) **Abstract**

Embodiments herein relate to techniques to integrate a capacitive voltage regulator in an integrated circuit (IC) package. The voltage regulator may provide a power supply to one or more load domains in the IC package. The transistors of the voltage regulator may be included on the same die as one or more of the load domains, another die, and/or an interposer of the IC package. The capacitors may be included in the same die as the transistors, in the interposer, in a package layer (e.g., package core), and/or in the same die as one or more of the load domains. Accordingly, the voltage regulator can be integrated close to the relevant load domains, delivering power with short current paths and thereby providing reduced input impedance, output impedance, and associated losses compared with prior techniques. Other embodiments may be described and claimed.

## Description

### BACKGROUND

Computing devices often rely on voltage converters, also referred to as voltage regulators, to obtain power. For example, direct current (DC)-to-DC voltage converters can convert a power supply at one DC voltage to another, typically lower DC voltage. A voltage converter can convert the main supply voltage of a computing device, such as 12-48 V, down to lower voltages, such as about 1 V. The lower voltages can be used by various components in the computing device, such as a Universal Serial Bus (USB) interface, memory such as dynamic random access memory (DRAM) and processing resources such as a central processing unit (CPU). However, it is challenging to supply power in an efficient and cost-effective manner.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
Figure 1 illustrates an example integrated circuit (IC) package with a capacitive voltage regulator, in accordance with various embodiments.
Figure 2A illustrates an example capacitive voltage regulator and associated current paths, in accordance with various embodiments.
Figure 2B illustrates an example capacitive voltage regulator in accordance with various embodiments.
Figure 3A illustrates another example IC package in accordance with various embodiments.
Figure 3B illustrates another example IC package in accordance with various embodiments.
Figure 3C illustrates another example IC package in accordance with various embodiments.
Figure 3D illustrates another example IC package in accordance with various embodiments.
Figure 4A illustrates another example IC package in accordance with various embodiments.
Figure 4B illustrates another example IC package in accordance with various embodiments.
Figure 5 illustrates another example IC package in accordance with various embodiments.
Figure 6A illustrates another example IC package in accordance with various embodiments.
Figure 6B illustrates another example IC package in accordance with various embodiments.
Figure 7A illustrates another example IC package in accordance with various embodiments.
Figure 7B illustrates another example IC package in accordance with various embodiments.
Figure 7C illustrates another example IC package in accordance with various embodiments.
Figure 8A illustrates another example IC package in accordance with various embodiments.
Figure 8B illustrates another example IC package in accordance with various embodiments.
Figure 9 illustrates another example IC package in accordance with various embodiments.
Figure 10 illustrates another example IC package in accordance with various embodiments.
Figure 11 illustrates an example of components that may be present in a computing system for implementing the techniques (e.g., operations, processes, methods, and methodologies) described herein, in accordance with various embodiments.

### DETAILED DESCRIPTION

Various embodiments herein provide techniques to integrate a capacitive voltage regulator (also referred to as a voltage converter) in an integrated circuit (IC) package. The voltage regulator may include transistors (e.g., field-effect transistors (FETs) and capacitors. The voltage regulator may provide a power supply to one or more load domains in the IC package. The load domains may include, for example, processor circuitry (e.g., central processing unit (CPU) circuitry, graphics processor circuitry, etc.), memory circuitry, input/output circuitry, and/or another suitable circuit load. In embodiments, the transistors of the voltage regulator may be included on the same die as one or more of the load domains, another die, and/or an interposer of the IC package. The capacitors may be included in the same die as the transistors, in the interposer (with or without the transistors being included in the interposer), in a package layer (e.g., package core), and/or in the same die as one or more of the load domains.

The capacitors may be implemented using silicon-based high-capacity capacitor technologies to create small volume, high current-density capacitive voltage regulators. In doing so, the voltage regulator can be integrated close to the relevant load domains, delivering power with short current paths and thereby providing reduced input impedance (Zin), output impedance (Zout), and associated I²R and voltage margin losses compared with prior techniques.

Furthermore, because the high-capacity capacitors provide much higher energy density compared with in-package inductors, the capacitive voltage regulators may provide excellent performance in terms of efficiency, power-density, and Vin/Vout capability.

With the demand for compute performance, there is a trend towards higher current requirements on IC power domains. Because of current/socket limitations, this requirement drives up the required input voltage at which current enters the socket.

At the same time, to improve the power efficiency, performance per watt, and performance to TCO (total cost of ownership) ratio, there is a demand for finer grained power domains to more precisely control where and when power is being consumed.

Additionally, the industry is moving away from single-die products to multi-chip package solutions that increasingly rely on advanced packaging. Advanced packaging provides the opportunity to tie several dies (also referred to as tiles or chiplets) closer together than before, but it may also increase the impedance of the input power delivery network (PDN), Zin, and output PDN, Zout, as current must go through multiple dies, bumps, through-silicon vias (TSVs), and so on, thereby increasing resistive I²R losses and/or voltage margin requirements.

These trends combined mean there is an increasingly large burden on voltage converters and regulators to 1) deliver the larger Vin/Vout ratios, 2) maintain or improve efficiency, and 3) do so in a smaller footprint/volume to minimize cost.

The prevailing solutions today rely on inductor-based switched-mode voltage converters. However, there is a physical limit as to how small an inductor can be and still provide decent performance (e.g., inductance, quality factor, equivalent series resistance, etc.). As such, these inductors tend to be larger in footprint and/or volume and have to be integrated into the package structure. This approach not only causes substantial practical difficulties, as the associated inductor routing can block other routing (e.g., signal routing, I/O routing, etc.), but also increases the length of the current loop, thereby increasing path resistance and losses.

Some IC packages use linear regulators. These can be much smaller, and appropriately scaled to the load domain requirements, but do not reduce the input current. As such, they do not provide a feasible solution for a wide range of product segments. Furthermore, the lack of a transformer effect also means their efficiency is very sensitive to their input PDN impedance, Zin, which tends to limit multithreaded performance.

As discussed above, embodiments herein provide capacitive voltage regulators integrated in an IC package close to the relevant load domains. The voltage regulators may provide power to the load domains with short current paths and reduced input impedance (Zin), output impedance (Zout), and associated I²R and voltage margin losses compared with prior techniques. Aspects of various embodiments will be further described with reference to the figures.

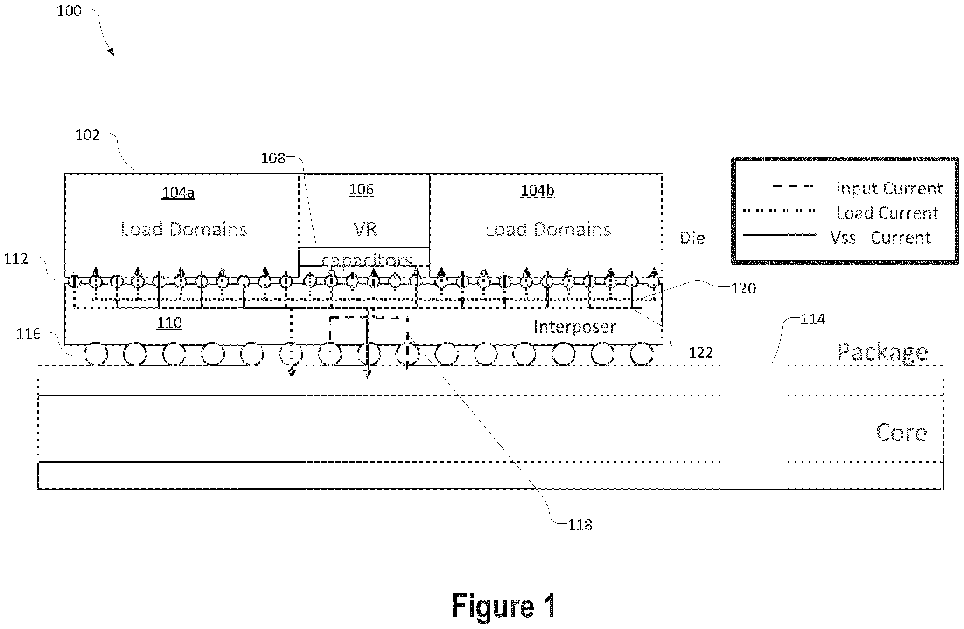

Figure 1 illustrates an IC package 100 in accordance with various embodiments. The IC package 100 includes a die 102 with load domains 104a-b. The die 102 further includes voltage regulator (VR) circuitry 106 and capacitors 108 that form a voltage regulator. The VR circuitry 106 may include transistors (e.g., power FETs). The die 102 may be coupled to an interposer (e.g., silicon interposer) 110 via microbumps 112. The interposer 110 may be coupled to a package structure 114 via bumps 116.

The voltage regulator may provide a power supply to one or more of the load domains 104a-b. The load domains 104a-b may include, for example, processor circuitry (e.g., CPU circuitry, graphics processor circuitry, etc.), memory circuitry, input/output circuitry, and/or another suitable circuit load.

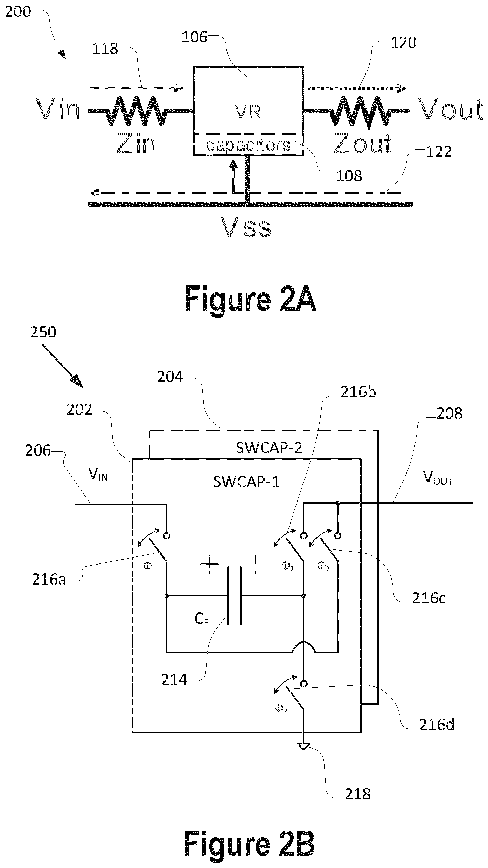

Figure 1 further illustrates the input current path 118, load (output) current path 120, and Vss current path 122. Additionally, Figure 2A schematically illustrates a voltage regulator 200 that may correspond to the voltage regulator of Figure 1, with VR circuitry 106 and capacitors 108. The voltage regulator 200 may receive an input voltage, Vin, and generate an output voltage, Vout. Additionally, the voltage regulator 200 may have an associated input impedance, Zin, and an output impedance, Zout.

Figure 2B illustrates an example circuit of a switched capacitor voltage regulator 250 (voltage regulator 250) in accordance with various embodiments. The voltage regulator 250 may correspond to the voltage regulator 200. The voltage regulator 250 may include one or more phases, such as a first phase 202 and a second phase 204 coupled in parallel between an input terminal 206 and an output terminal 208. The first phase 202 includes a capacitor 214 and transistors 216a-d (depicted as switches). The transistors 216a and 216b may receive the first control signal (Φ₁) and the transistors 216c and 216d may receive the second control signal (Φ₂). The first and second control signals may both alternate between a first logic value (e.g., logic 0) and a second logic value (e.g., logic 1). The first control signal may have the first logic value when the second control signal has the second logic value, and may have the second logic value when the second control signal has the first logic value. In some embodiments, the first and second control signals may have a duty cycle of 50%, and/or may correspond to pulse width modulation (PWM) and/or pulse frequency modulation (PFM) control signals.

The transistors 216a-d may turn on and off responsive to the first and second control signals to repeatedly switch the capacitor 214 between a first state and a second state. In the first state, the capacitor 214 may be coupled between the input terminal 206 and the output terminal 208. In the second state, the capacitor 214 may be coupled between the output terminal 208 and ground 218.

It will be apparent that the voltage regulator 250 is presented merely as an example of a capacitive voltage regulator, and other configurations of a capacitive voltage regulator may be used in accordance with various embodiments.

In other IC package configurations that use a voltage regulator with one or more inductors, the inductors are typically implemented in the package structure 114 to enable inductors of sufficient size and performance. However, this causes the input and output current paths to be relatively long, passing from the VR circuitry on the top die, through the interposer, to the package inductor through the package core, and back up to the load domains through the interposer. The large current loop results in higher resistance and associated losses. In contrast, the capacitive voltage regulator of IC package 100 provides significantly shorter current paths, with reduced input impedance (Zin), output impedance (Zout), and associated I²R and voltage margin losses compared with prior techniques. For example, as shown in Figure 1, the input circuit path 118 and output circuit path 120 may be routed through the interposer 110. However, it is also possible to use the top metal layers of the package structure 114 to distribute the output current, which would still provide a shorter current path than inductor-based voltage regulators and may provide lower resistance compared with on-die metal layers.

In various embodiments, the capacitors 108 may be implemented using silicon-based high-capacity capacitor technologies to create small volume, high current-density capacitors and enabling the capacitors to be located close to VR circuitry 106 (e.g., in the die 102 as shown in Figure 1). For example, the capacitors 108 may include metal-oxide-semiconductor (MOS) capacitors, device capacitors (e.g., a transistor connected to form a capacitor), metal-insulator-metal capacitors, metal-oxide-metal capacitors, deep trench capacitors, and/or another suitable type of capacitors or a combination thereof.

As mentioned, the voltage regulator formed by the VR circuitry 106 and capacitors 108 may receive an input voltage and generate an output voltage that is provided to the load domains 104a-b. For example, the input voltage may be a supply voltage of a battery and/or mains power source. In some embodiments, the associated device may have a main voltage regulator to convert the supply voltage of the battery and/or mains power source to an intermediate voltage (e.g., that is lower than the supply voltage), and the intermediate voltage may be provided to the voltage regulator of the IC package 100 as the input voltage. The output voltage may be a supply voltage that is used by the load domains 104a-b and/or another suitable voltage.

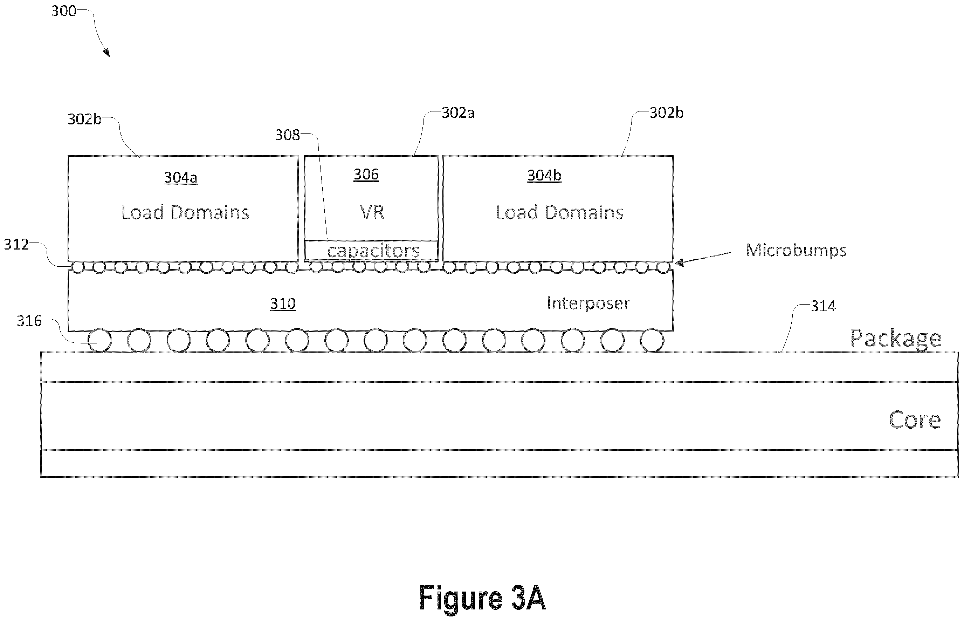

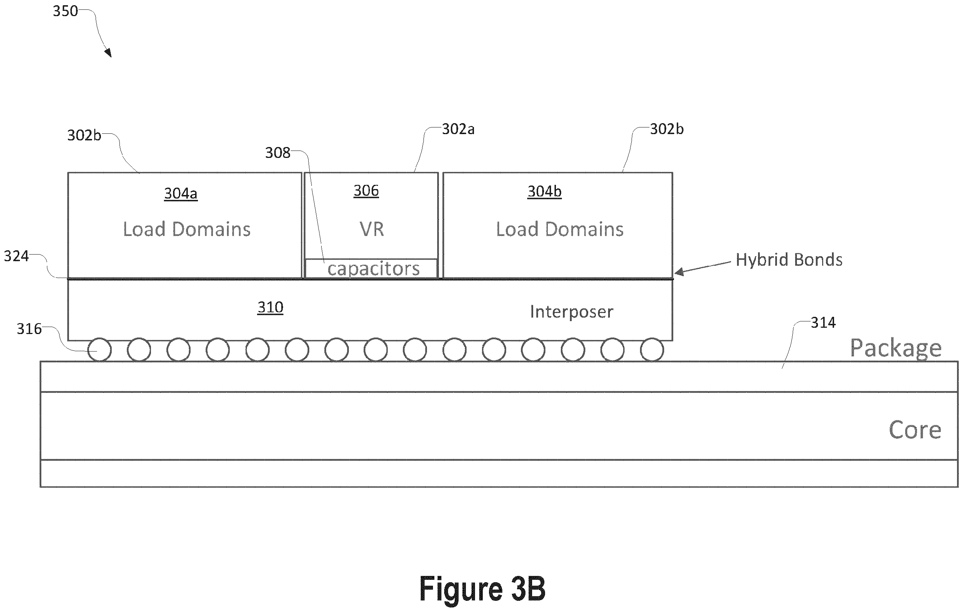

Figure 3A illustrates another example IC package 300 in accordance with various embodiments. The IC package 300 may be similar to the IC package 100, except that the VR circuitry 306 and capacitors 308 are included in a separate die 302a from dies 302b and 302c that include respective load domains 304a-b. The dies 302a-c are coupled to the interposer 310 via microbumps 312. In other embodiments, the dies 302a-c may be coupled to the interposer 310 via hybrid bonds 324 (also referred to as hybrid bonded interconnects (HBI) on the interposer 310 instead of microbumps, as shown in IC package 350 of Figure 3B.

Having the VR circuitry 306 on a separate die from the load domains enables different manufacturing processes to be used for the VR circuitry 306 compared to the load domains. For example, the VR circuitry 306 may use a less advanced process than the load domains, which may reduce the cost of the IC package 300. Additionally, or alternatively, the process used for the VR circuitry 306 may generate larger transistors than are used in the load domains 304a-b, which may provide better performance for power delivery.

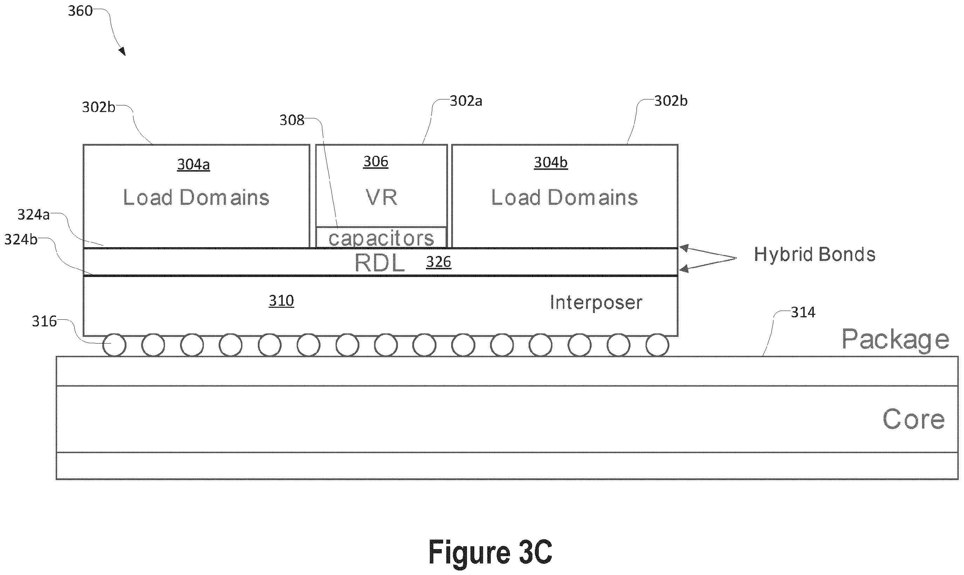

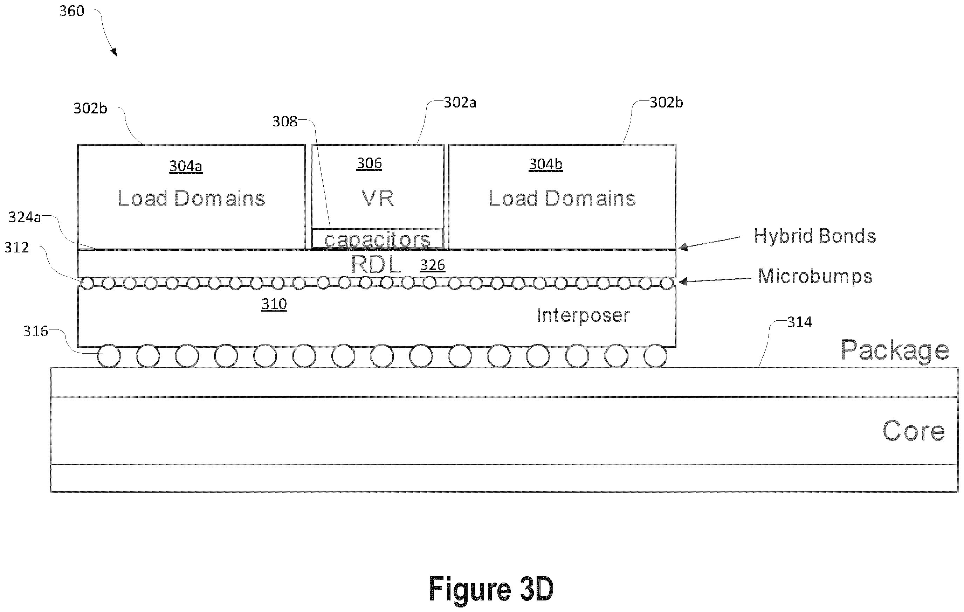

Figure 3C illustrates another example IC package 360 that includes a redistribution layer (RDL) 326 coupled to the dies 302a-c and interposer 310. For example, a first side of the RDL 326 may be coupled to the dies 302a-c and a second side of the RDL 326 (opposite the first side) may be coupled to the interposer 310. The input current and/or output current of the voltage regulator may be routed through the RDL 326. The RDL 326 may include thicker metal layers than are typically used in the interposer 310 and/or package structure 314, thereby providing reduced resistance. Accordingly, the RDL 326 may improve the lateral routing resistance from the voltage regulator to the load domains 304a-b, thus lower the output impedance, Zout, and associated resistive losses and voltage margin requirements. Hybrid bonds and/or microbumps may be used to couple the dies 302a-c to the RDL 326 and/or to couple the RDL 326 to the interposer 310. For example, the IC package 360 shown in Figure 3C includes hybrid bonds 326a to couple the dies 302a-c to the RDL 326 and hybrid bonds 326b to couple the RDL 326 to the interposer 310. Figure 3D illustrates another similar IC package 370 that includes hybrid bonds 326 to couple the dies 302a-c to the RDL 326 and microbumps 312 to couple the RDL 326 to the interposer 310.

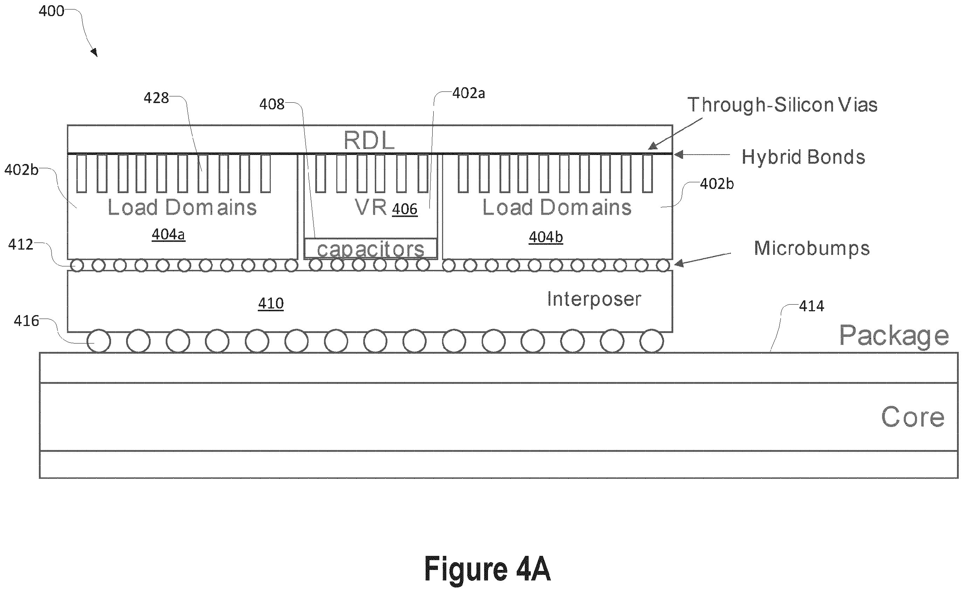

Figure 4A illustrates another example IC package 400 in accordance with various embodiments. The IC package 400 includes a RDL 426 coupled to an opposite side of the dies 402a-c than the RDL 326 of Figure 3C. For example, a first side (e.g., front side) of the dies 402a-c may be coupled to the interposer 410 (e.g., via microbumps 412) the RDL 426 may be coupled to a second side (e.g., back side) of the dies 402a-c (e.g., via hybrid bonds). The dies 402a-c may include TSVs 428 to couple the circuitry of the dies 402a-c to the RDL 426.

The configuration of IC package 400 enables power distribution to be performed on the backside of the dies 402a-c through the RDL 426. This frees up more of the microbumps 412 and/or die area on the front side to be used for distribution of I/O signals and/or other signals, thereby enabling increased bandwidth.

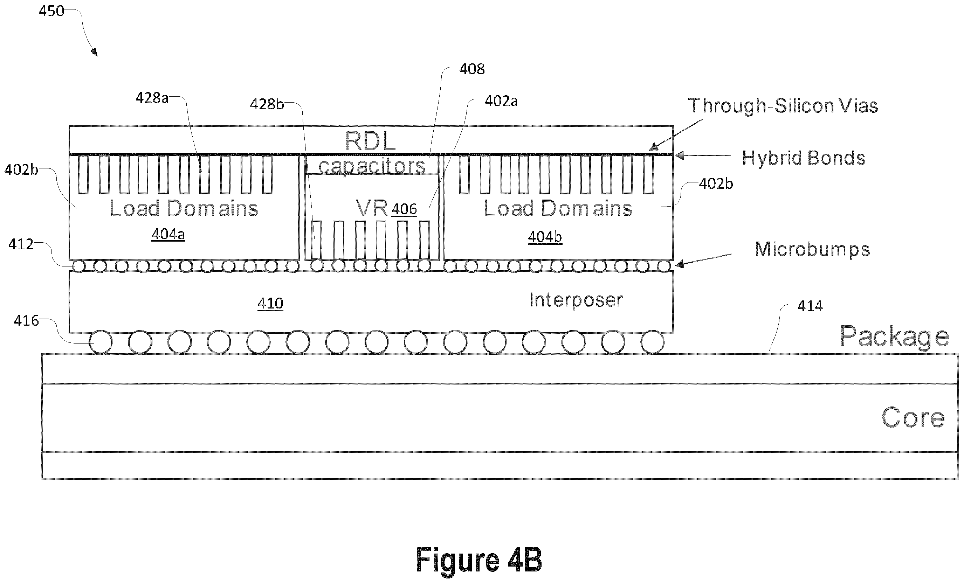

Figure 4B illustrates another example IC package 450 in accordance with various embodiments. The IC package 450 may be similar to the IC package 400, except that the capacitors 408 may be located on a side of the die 402a that is adjacent to the RDL 426 (as opposed to the IC package 400, in which the capacitors 408 are located on the side of the die 402a that is adjacent to the interposer 410). The IC package 450 may include TSVs 428a to couple circuitry of the load domains 404a-b to the RDL 426, and TSVs 428b to couple the VR circuitry 406 to the interposer 410 via microbumps 412.

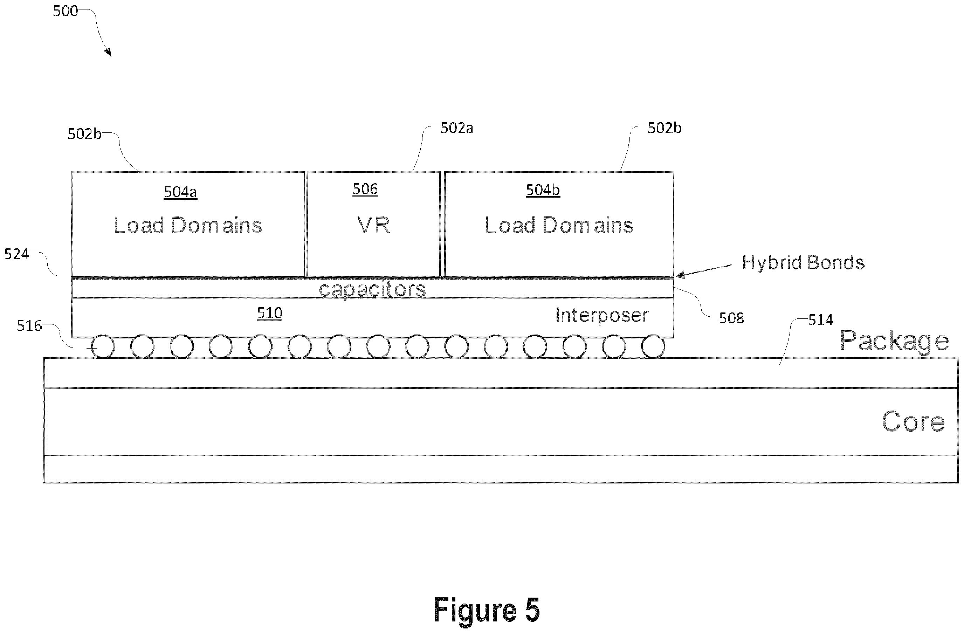

In some embodiments, some or all of the capacitors of the voltage regulator may be included in a different die or structure from the die that includes the VR circuitry. For example, Figure 5 illustrates an example IC package 500 in which the VR circuitry 506 is included in die 502a and the capacitors 508 are included in the interposer 510. This enables the capacitors 508 to be disposed in a larger area and/or volume, which may enable larger capacitors to be used. The larger capacitors may provide increased output current capability and efficiency, among other benefits. Alternatively, or additionally, the larger capacitors may enable the voltage regulator to handle a greater input voltage.

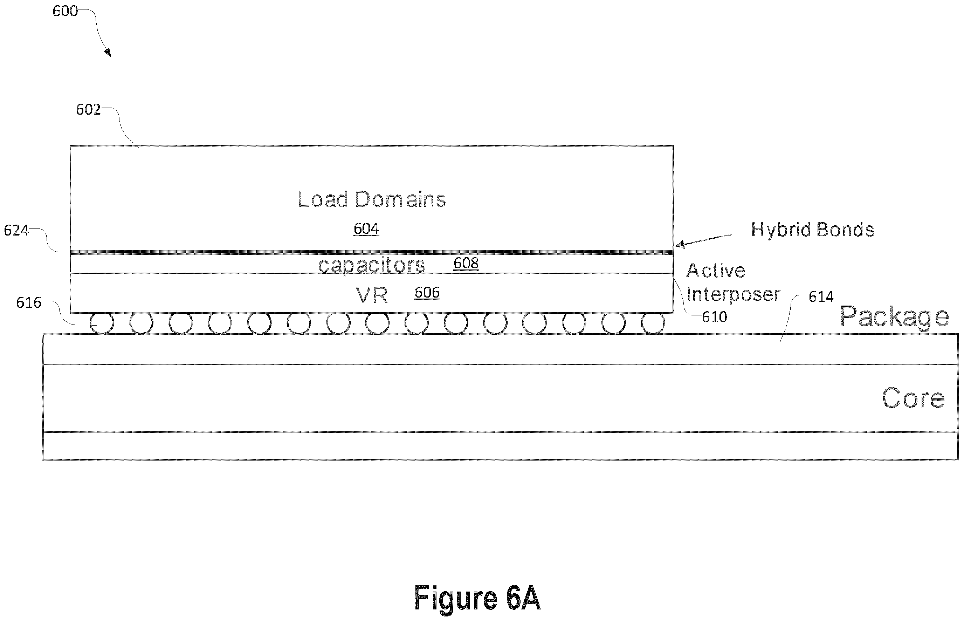

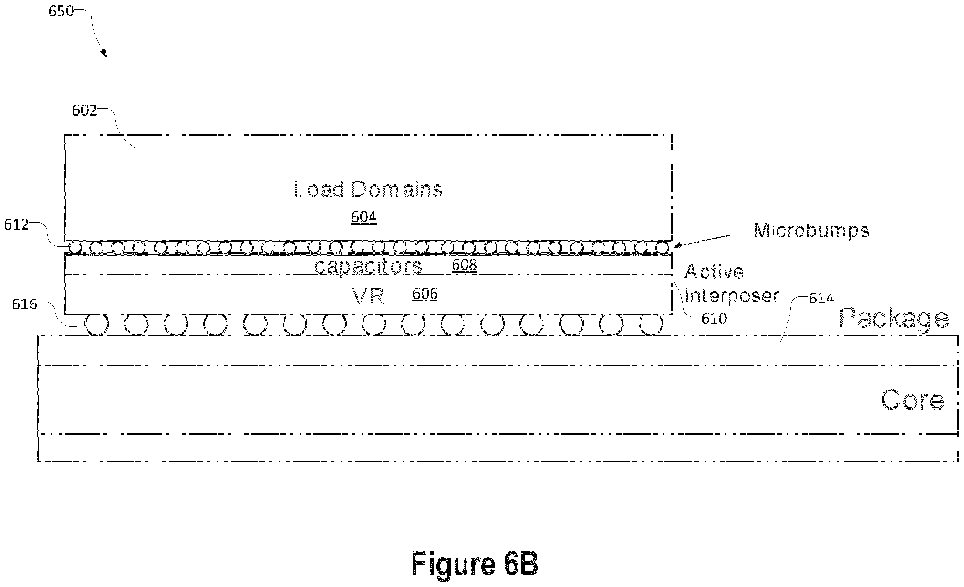

Figure 6A illustrates another IC package 600 in accordance with various embodiments. In IC package 600, the VR circuitry 606 and associated capacitors 608 are both included in the interposer 610 (e.g., an active interposer). The interposer 610 may be coupled to die 602, which includes one or more load domains 604, via hybrid bonds 624 (as shown in Figure 6A), microbumps, and/or another suitable mechanism. For example, Figure 6B illustrates an IC package 650 that is similar to the IC package 600 except that microbumps 612 are used to couple the die 602 to the interposer 610.

The configuration of IC package 600 and/or 650 may enable the output current to flow vertically from the voltage regulator to the load domains 604, and may further reduce the length of the current path and provide better efficiency.

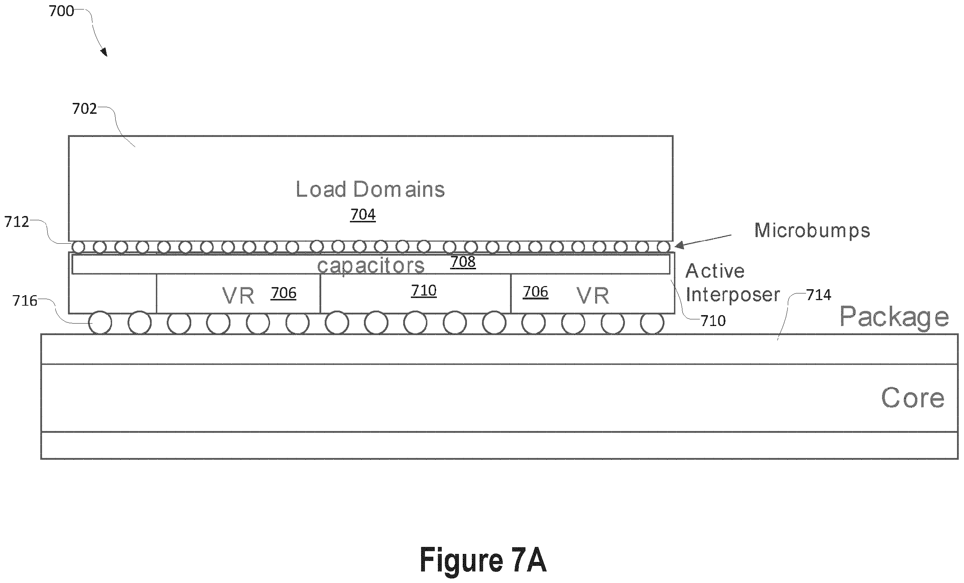

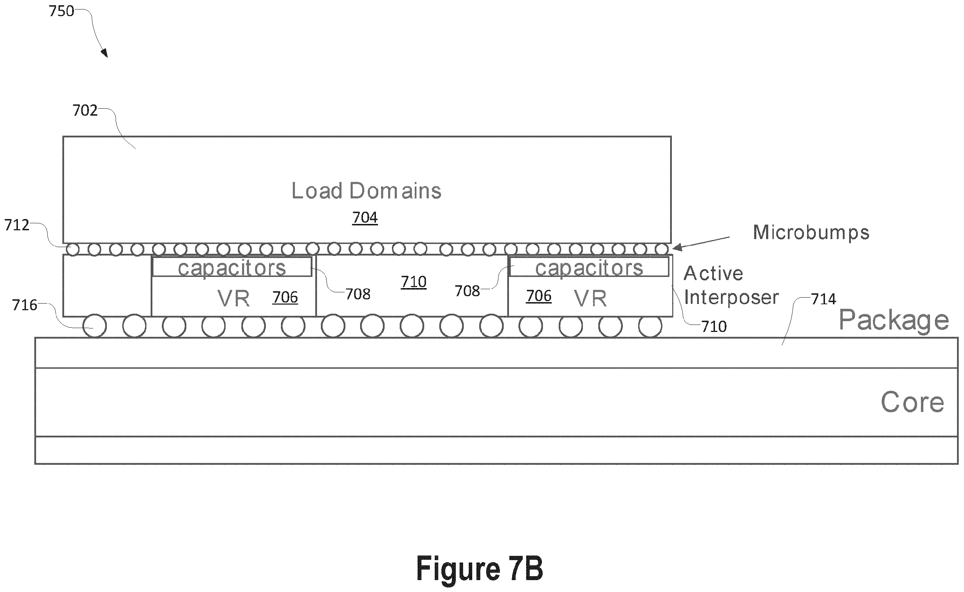

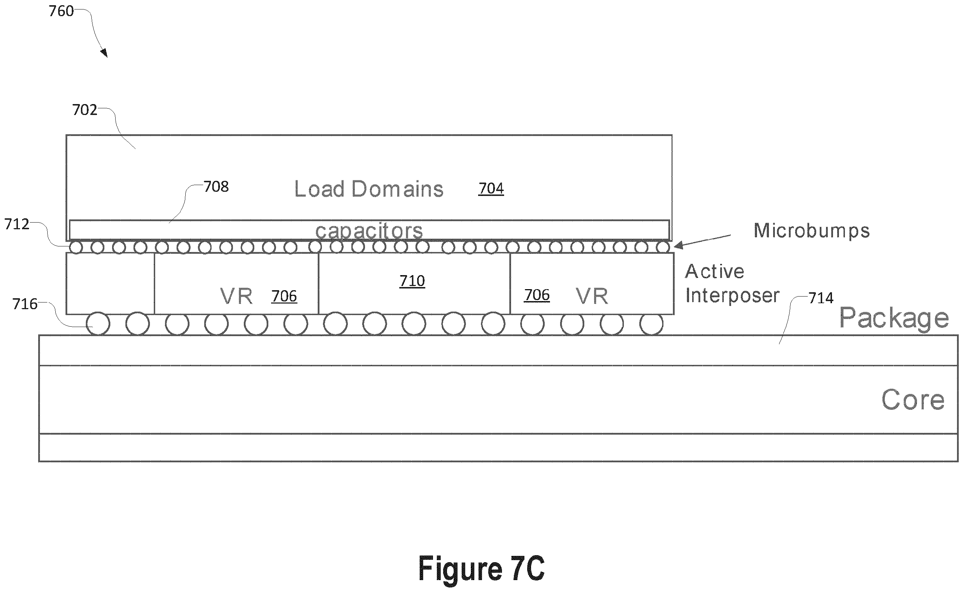

Figures 7A, 7B, and 7C illustrate further examples of IC packages with the VR circuitry 706 included in the interposer 710, in accordance with various embodiments. As shown, the VR circuitry 706 is implemented in only a portion of the cross-sectional area of the interposer 710. This may enable the active interposer 710 to also include other circuitry, such as memory circuitry, I/O circuitry, etc. The IC packages may include multiple regions of VR circuitry 706, which may implement one or multiple voltage regulators.

Figure 7A illustrates an example IC package 700 in which the capacitors 708 are also implemented in the interposer 710. The capacitors 708 may be disposed in a larger cross-sectional area than the VR circuitry 706. As discussed above with respect to Figure 5, this may enable larger capacitors to be used, thereby providing increased output current capability and efficiency and/or the ability to handle greater input voltage.

Figure 7B illustrates another example IC package 750 in which the VR circuitry 706 is implemented in the interposer 710 and the capacitors 708 are implemented in the die 702 that includes the load domains 704. The capacitors 708 may be disposed in a larger cross-sectional area than the VR circuitry 706, as shown, or may be disposed in the same or smaller cross-sectional area.

Figure 7C illustrates another example IC package 760 in which the VR circuitry 706 and capacitors 708 are included in the interposer 710 and both the VR circuitry 706 and capacitors 708 take up only a portion of the cross-sectional area of the interposer 710. For example, as shown in Figure 7C, the capacitors 708 may be disposed in substantially the same cross-sectional area as the VR circuitry 706. In some configurations, it may be beneficial to not have the capacitors 708 near other circuitry, such as input/output circuitry, for which the capacitors 708 may cause interference and/or otherwise degrade performance.

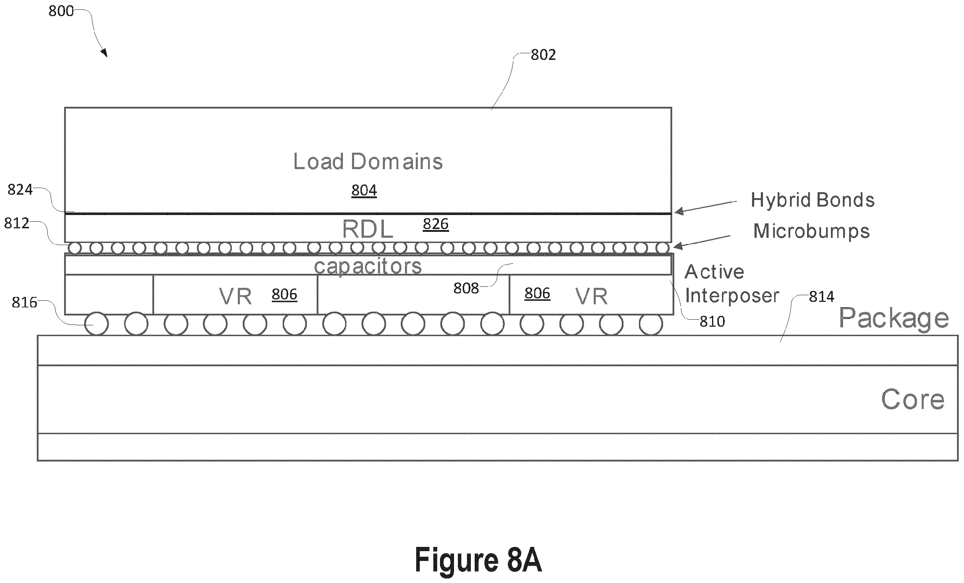

Figure 8A illustrates another example IC package 800 in accordance with various embodiments. The IC package 800 may be similar to IC package 700 of Figure 7, with VR circuitry 806 and capacitors 808 included in the interposer 810. However, IC package 800 may include an RDL 826 coupled between the interposer 810 and the die 802 that includes the load domains 804. For some load domains, the current consumption profile is significantly non-uniform across the die area. Additionally, or alternatively, when the VR circuitry 806 does not take up the full cross-sectional area of the interposer, there can still be substantial lateral current flow. The inclusion of the RDL 826 in IC package 800 may reduce the lateral conduction losses.

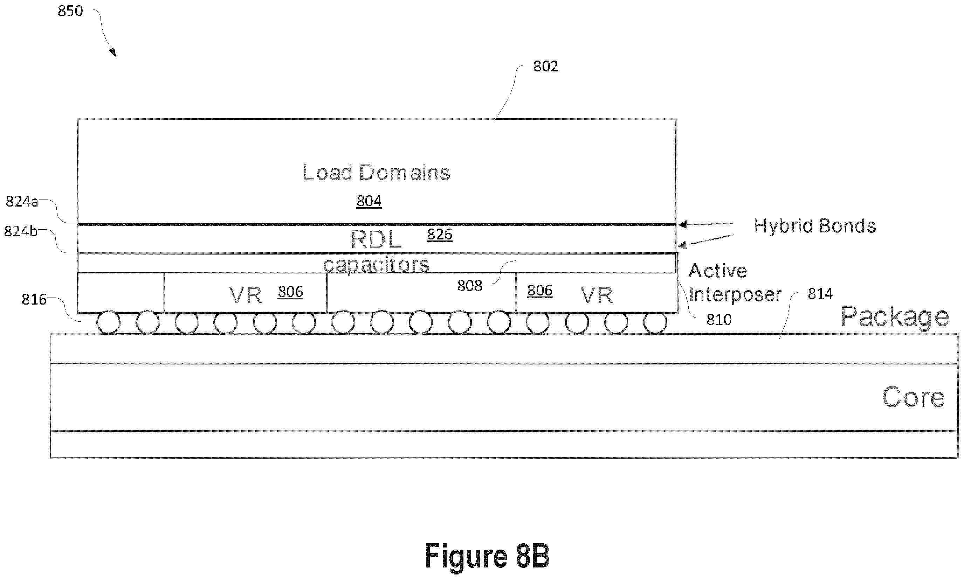

As shown in the example implementation of IC package 800 in Figure 8A, the RDL 826 may be coupled to the die 802 via hybrid bonds 824 and may be coupled to the interposer 810 via microbumps 812. Figure 8B illustrates an IC package 850 that is similar to IC package 800 except that respective hybrid bonds 824a-b are used to couple the RDL 826 to the die 802 and to the interposer 810. It will be apparent that other mechanisms and/or combinations of interconnect/routing structures may be used in various embodiments.

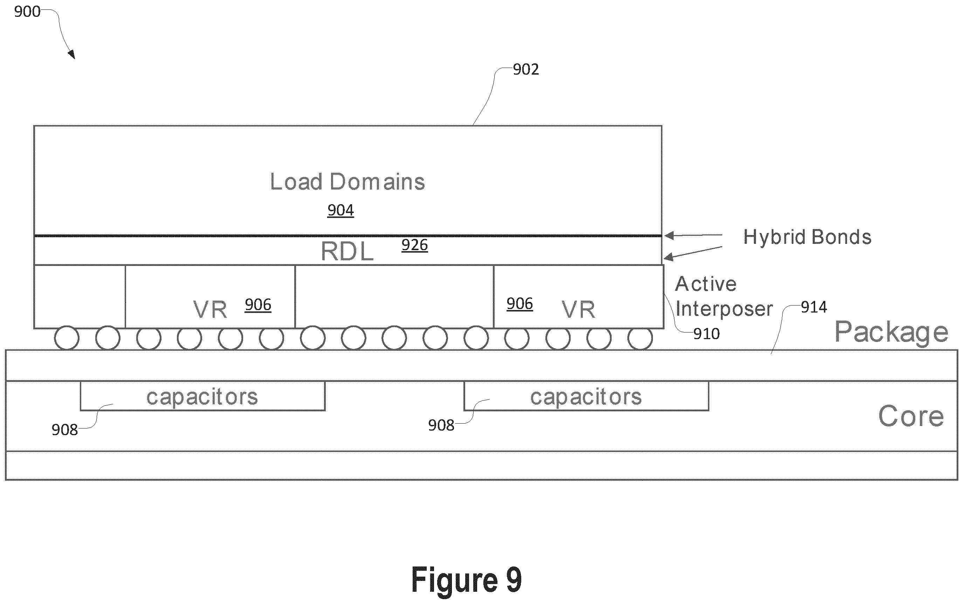

Figure 9 illustrates another example IC package 900 in accordance with various embodiments. The IC package 900 includes VR circuitry 906 in interposer 910 and associated capacitors 908 in the package structure 914 (e.g., in a core of the package structure 914). The IC package 900 further includes an RDL 926 coupled between the interposer 910 and the die 902 that includes the load domains 904. In other embodiments, the RDL 926 may be omitted and the interposer 910 may be coupled to the die 902 via microbumps, hybrid bonds, and/or another suitable mechanism.

In some embodiments, the capacitors 908 may be integrated onto a die that is embedded into the package structure 914 (e.g., package core). The thickness of the package structure and/or package core may enable a larger volume capacitor to be used than embodiments in which the capacitors 908 are included in other portions of the IC package. Additionally, or alternatively, integrating the capacitors 908 into the package structure 914 may be less expensive than other configurations. The current path for the IC package 900 may be longer than other configurations described herein, but still shorter than prior techniques that utilize an inductor in the package structure.

It will be apparent that the IC packages shown in Figures 1-9 are merely example implementations, and the techniques and configurations may be combined in any suitable manner in accordance with various embodiments. For example, in some embodiments, the capacitors of the voltage regulator may be disposed in multiple locations within the IC package.

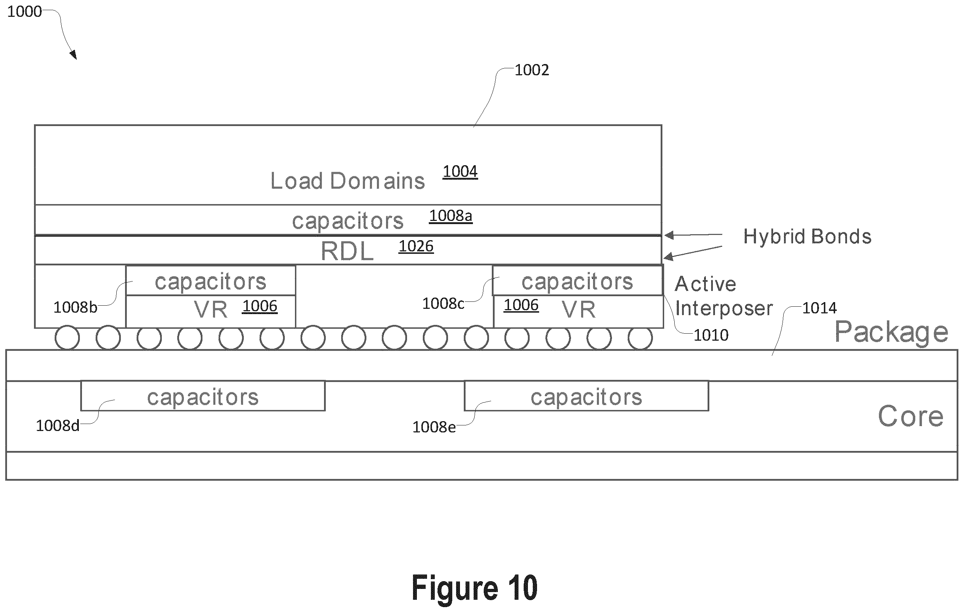

Figure 10 illustrates one example IC package 1000 in accordance with various embodiments. The IC package 1000 includes VR circuitry 1006 in interposer 1010. The associated capacitors 1008a-e of the voltage regulator are included in the die 1002 that includes the load domains 1004, the interposer 1010, and the package structure 1014. In embodiments, these capacitors 1008a-e may be electrically coupled in parallel, or may be unique capacitors in a given capacitive voltage regulator topology.

Having the capacitors in different locations of the IC package may enable different sizes and/or types of capacitors to be used, which may provide one or more benefits such as improved performance, reduced cost, etc.

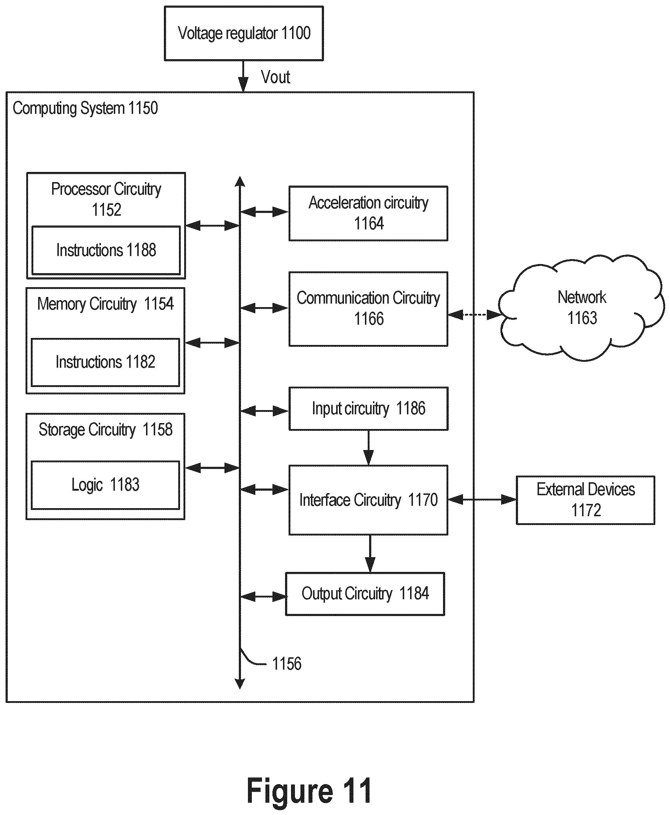

Figure 11 illustrates an example of components that may be present in a computing system 1150 for implementing the techniques (e.g., operations, processes, methods, and methodologies) described herein, in accordance with various embodiments. The voltage regulator 1100 may correspond to the voltage regulators described herein (e.g., with reference to Figures 1-10) and may provide a power supply (e.g., output voltage) to one or more of the components of the computing system 1150 (which may correspond to the load domains described herein). In some embodiments, the voltage may be controlled by control signals provided by the processor circuitry 1152 (e.g., a power management unit included in the processor circuitry 1152).

The memory circuitry 1154 may store instructions and the processor circuitry 1152 may execute the instructions to perform the functions described herein.

The computing system 1150 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1150, or as components otherwise incorporated within a chassis of a larger system. For one embodiment, at least one processor 1152 may be packaged together with computational logic 1182 and configured to practice aspects of various example embodiments described herein to form a System in Package (SiP) or a System on Chip (SoC).

The system 1150 includes processor circuitry in the form of one or more processors 1152. The processor circuitry 1152 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1152 may include one or more hardware accelerators (e.g., same or similar to acceleration circuitry 1164), which may be microprocessors, programmable processing devices (e.g., FPGA, ASIC, etc.), or the like. The one or more accelerators may include, for example, computer vision and/or deep learning accelerators. In some implementations, the processor circuitry 1152 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1152 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1152 may be coupled with or may include memory/storage and may be configured to execute instructions stored in the memory/storage to enable various applications or operating systems to run on the platform 1150. The processors (or cores) 1152 is configured to operate application software to provide a specific service to a user of the platform 1150. In some embodiments, the processor(s) 1152 may be a special-purpose processor(s)/controller(s) configured (or configurable) to operate according to the various embodiments herein.

As examples, the processor(s) 1152 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1152 may be a part of a system on a chip (SoC), System-in-Package (SiP), a multi-chip package (MCP), and/or the like, in which the processor(s) 1152 and other components are formed into a single integrated circuit, or a single package, such as the Edison^{™} or Galileo^{™} SoC boards from Intel^{®} Corporation. Other examples of the processor(s) 1152 are mentioned elsewhere in the present disclosure.

The system 1150 may include or be coupled to acceleration circuitry 1164, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1164 may comprise logic blocks or logic fabric and other interconnected resources that may be programmed (configured) to perform various functions, such as the procedures, methods, functions, etc. of the various embodiments discussed herein. In such implementations, the acceleration circuitry 1164 may also include memory cells (e.g., EPROM, EEPROM, flash memory, static memory (e.g., SRAM, anti-fuses, etc.) used to store logic blocks, logic fabric, data, etc. in LUTs and the like.

In some implementations, the processor circuitry 1152 and/or acceleration circuitry 1164 may include hardware elements specifically tailored for machine learning and/or artificial intelligence (Al) functionality. In these implementations, the processor circuitry 1152 and/or acceleration circuitry 1164 may be, or may include, an Al engine chip that can run many different kinds of Al instruction sets once loaded with the appropriate weightings and training code. Additionally or alternatively, the processor circuitry 1152 and/or acceleration circuitry 1164 may be, or may include, Al accelerator(s), which may be one or more of the aforementioned hardware accelerators designed for hardware acceleration of AI applications. As examples, these processor(s) or accelerators may be a cluster of artificial intelligence (Al) GPUs, tensor processing units (TPUs) developed by Google^{®} Inc., Real Al Processors (RAPs^{™}) provided by AlphaICs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1152 and/or acceleration circuitry 1164 and/or hardware accelerator circuitry may be implemented as Al accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 orA12 Bionic SoC, the Neural Processing Unit (NPU) within the HiSilicon Kirin 970 provided by Huawei^{®}, and/or the like. In some hardware-based implementations, individual subsystems of system 1150 may be operated by the respective Al accelerating co-processor(s), Al GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1150 also includes system memory 1154. Any number of memory devices may be used to provide for a given amount of system memory. As examples, the memory 1154 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1154 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1154 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1158 provides persistent storage of information such as data, applications, operating systems and so forth. In an example, the storage 1158 may be implemented via a solid-state disk drive (SSDD) and/or high-speed electrically erasable memory (commonly referred to as "flash memory"). Other devices that may be used for the storage 1158 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1154 and/or storage circuitry 1158 may also incorporate three-dimensional (3D) cross-point (XPOINT) memories from Intel@ and Micron^{®}.

The memory circuitry 1154 and/or storage circuitry 1158 is/are configured to store computational logic 1183 in the form of software, firmware, microcode, or hardware-level instructions to implement the techniques described herein. The computational logic 1183 may be employed to store working copies and/or permanent copies of programming instructions, or data to create the programming instructions, for the operation of various components of system 1150 (e.g., drivers, libraries, application programming interfaces (APIs), etc.), an operating system of system 1150, one or more applications, and/or for carrying out the embodiments discussed herein. The computational logic 1183 may be stored or loaded into memory circuitry 1154 as instructions 1182, or data to create the instructions 1182, which are then accessed for execution by the processor circuitry 1152 to carry out the functions described herein. The processor circuitry 1152 and/or the acceleration circuitry 1164 accesses the memory circuitry 1154 and/or the storage circuitry 1158 over the interconnect (IX) 1156. The instructions 1182 direct the processor circuitry 1152 to perform a specific sequence or flow of actions, for example, as described with respect to flowchart(s) and block diagram(s) of operations and functionality depicted previously. The various elements may be implemented by assembler instructions supported by processor circuitry 1152 or high-level languages that may be compiled into instructions 1188, or data to create the instructions 1188, to be executed by the processor circuitry 1152. The permanent copy of the programming instructions may be placed into persistent storage devices of storage circuitry 1158 in the factory or in the field through, for example, a distribution medium (not shown), through a communication interface (e.g., from a distribution server (not shown)), over-the-air (OTA), or any combination thereof.

The IX 1156 couples the processor 1152 to communication circuitry 1166 for communications with other devices, such as a remote server (not shown) and the like. The communication circuitry 1166 is a hardware element, or collection of hardware elements, used to communicate over one or more networks 1163 and/or with other devices. In one example, communication circuitry 1166 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1166 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1156 also couples the processor 1152 to interface circuitry 1170 that is used to connect system 1150 with one or more external devices 1172. The external devices 1172 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1150, which are referred to as input circuitry 1186 and output circuitry 1184. The input circuitry 1186 and output circuitry 1184 include one or more user interfaces designed to enable user interaction with the platform 1150 and/or peripheral component interfaces designed to enable peripheral component interaction with the platform 1150. Input circuitry 1186 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1184 may be included to show information or otherwise convey information, such as sensor readings, actuator position(s), or other like information. Data and/or graphics may be displayed on one or more user interface components of the output circuitry 1184. Output circuitry 1184 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1150. The output circuitry 1184 may also include speakers and/or other audio emitting devices, printer(s), and/or the like. Additionally or alternatively, sensor(s) may be used as the input circuitry 1184 (e.g., an image capture device, motion capture device, or the like) and one or more actuators may be used as the output device circuitry 1184 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1150 may communicate over the IX 1156. The IX 1156 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1156 may be a proprietary bus, for example, used in a SoC based system.

The number, capability, and/or capacity of the elements of system 1150 may vary, depending on whether computing system 1150 is used as a stationary computing device (e.g., a server computer in a data center, a workstation, a desktop computer, etc.) or a mobile computing device (e.g., a smartphone, tablet computing device, laptop computer, game console, loT device, etc.). In various implementations, the computing device system 1150 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are provided below.

Example 1 is an apparatus comprising: a first die that includes a load; and a capacitive voltage regulator to provide a power supply to the load, wherein the capacitive voltage regulator includes transistors and capacitors, and wherein the transistors are included in the first die or in a second die that is different than the first die.

Example 2 is the apparatus of example 1, wherein the capacitors are included in the second die.

Example 3 is the apparatus of example 1 or example 2, further comprising an interposer, wherein the first die and the second die are coupled to the interposer.

Example 4 is the apparatus of example 3, wherein the first die and the second die are coupled to the interposer via microbumps or hybrid bonds.

Example 5 is the apparatus of example 3, further comprising a redistribution layer (RDL) coupled to the interposer and the first and second dies.

Example 6 is the apparatus of example 3 or example 4, further comprising a redistribution layer (RDL) coupled to the first and second dies on an opposite side from the interposer.

Example 7 is the apparatus of any of examples 3-6, wherein the capacitors are at least partially included in the interposer.

Example 8 is the apparatus of example 1 or example 2, wherein the second die is an active interposer, and wherein the first die is mounted on the active interposer.

Example 9 is the apparatus of example 8, wherein the active interposer includes multiple voltage regulators.

Example 10 is the apparatus of any of examples 1-9, wherein the capacitors encompass a larger cross-sectional area than the transistors.

Example 11 is the apparatus of any of examples 1-10, wherein the capacitors are at least partially included in the first die.

Example 12 is the apparatus of any of examples 1-11, further comprising a package layer, wherein the capacitors are at least partially included in the package layer.

Example 13 is the apparatus of any of examples 1-13, wherein the capacitors include one or more metal-oxide-semiconductor capacitors, device capacitors, metal-insulator-metal capacitors, metal-oxide-metal capacitors, or deep trench capacitors.

Example 14 is an integrated circuit (IC) package comprising: a package layer; an interposer coupled to the package layer; a first die coupled to the interposer, wherein the first die includes a load; and a voltage regulator to provide a power supply to the load, wherein the voltage regulator includes transistors and capacitors, and wherein the transistors are included in the interposer or in a second die that is coupled to the interposer.

Example 15 is the IC package of example 14, wherein the capacitors are at least partially included in the interposer, the second die, the first die, or the package layer.

Example 16 is the IC package of example 14 or example 15, wherein the transistors and the capacitors are included in the second die, and wherein the IC package further includes a redistribution layer (RDL) coupled to the first and second dies.

Example 17 is the IC package of any of examples 14-16, wherein the capacitors encompass a larger cross-sectional area than the transistors.

Example 18 is the IC package of any of examples 14-17, wherein the capacitors include one or more metal-oxide-semiconductor capacitors, device capacitors, metal-insulator-metal capacitors, metal-oxide-metal capacitors, or deep trench capacitors.

Example 19 is the IC package of any of examples 14-18, wherein the voltage regulator does not include an inductor.

Example 20 is a system comprising: a battery interface to receive a power supply from a battery; and an integrated circuit (IC) package. The IC package includes: an interposer; a first die coupled to the interposer, wherein the first die includes a load domain; and a capacitive voltage regulator to receive an input voltage that corresponds to the power supply and generate an output voltage that is provided to the load domain, wherein capacitors of the capacitive voltage regulator are included in one or more of the first die, the interposer, or a second die that is coupled to the interposer.

Example 21 is the system of example 20, wherein the input voltage is the power supply or an intermediate voltage generated from the power supply.

Example 22 is the system of example 20 or example 21, wherein transistors of the capacitive voltage regulator are included in the interposer or in the second die.

Example 23 is the system of example 22, wherein the capacitors encompass a larger cross-sectional area than the transistors.

Example 24 is the system of any of examples 20-23, further comprising the battery or a display that is coupled to the IC package.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus comprising:
a first die that includes a load; and
a capacitive voltage regulator to provide a power supply to the load, wherein the capacitive voltage regulator includes transistors and capacitors, and wherein the transistors are included in the first die or in a second die that is different than the first die.

2. The apparatus of claim 1, wherein the capacitors are included in the first die or in the second die.

3. The apparatus of claim 1 or 2, further comprising an interposer, wherein the first die and the second die are coupled to the interposer.

4. The apparatus of claim 3, wherein the first die and the second die are coupled to the interposer via microbumps or hybrid bonds.

5. The apparatus of claim 3, further comprising a redistribution layer (RDL) coupled to the interposer and the first and second dies.

6. The apparatus of claim 3, further comprising a redistribution layer (RDL) coupled to the first and second dies on an opposite side from the interposer.

7. The apparatus of claim 3, 4, 5, or 6, wherein the capacitors are at least partially included in the interposer.

8. The apparatus of claim 1, or 2, wherein the second die is an active interposer, and wherein the first die is mounted on the active interposer.

9. The apparatus of claim 8, wherein the active interposer includes multiple voltage regulators.

10. The apparatus of claim 1, further comprising a package layer, wherein the capacitors are at least partially included in the package layer.

11. A system comprising:
a battery interface to receive a power supply from a battery; and
an integrated circuit (IC) package that includes:
an interposer;
a first die coupled to the interposer, wherein the first die includes a load domain;
and
a capacitive voltage regulator to receive an input voltage that corresponds to the power supply and generate an output voltage that is provided to the load domain, wherein capacitors of the capacitive voltage regulator are included in one or more of the first die, the interposer, or a second die that is coupled to the interposer.

12. The system of claim 1, wherein the input voltage is the power supply or an intermediate voltage generated from the power supply and wherein transistors of the capacitive voltage regulator are included in the interposer or in the second die.

13. A method comprising:
providing a first die that includes a load; and
providing a capacitive voltage regulator to provide a power supply to the load, wherein the capacitive voltage regulator includes transistors and capacitors, and wherein the transistors are included in the first die or in a second die that is different than the first die.

14. The method of claim 13, further comprising: including the capacitors in the second die.

15. The method of claim 13 or 14, further comprising: coupling the first die and the second die to the interposer.
